# EUROPEAN PATENT APPLICATION

(11) **EP 1 667 225 A1**
(43) Date of publication of application: **07.06.2006**
(21) Application number: 04788014.1
(22) Date of filing: 22.09.2004
(51) Int. Cl.: H01L 23/32

(54) **INTERPOSER AND MULTILAYER PRINTED WIRING BOARD**

(30) Priority: 24.09.2003 JP 2003331360; 11.11.2003 JP 2003381048
(71) Applicant: Ibiden Co.,Ltd., Oogaki City 503-8604 (JP)
(72) Inventor: KARIYA, Takashi; c/o IBIDEN Co., Ltd.1, Ibi-gun Gifu 5010695 (JP); FURUTANI, Toshiki; c/o IBIDEN Co., Ltd., Ibi-gun Gifu 5010695 (JP)
(74) Representative: Vossius & Partner
(86) International application number: PCT/JP2004/013831
(87) International publication number: WO 2005/029581

(57) **Abstract**

Provides an interposer capable of preventing breaking of wiring pattern with an IC chip loaded on a package substrate. Stress due to a difference in thermal expansion coefficient between a multilayer printed wiring board 10 having a large thermal expansion and the IC 110 chip having a small thermal expansion can be absorbed by locating the interposer 70 between the package substrate 10 and the IC chip 110. Particularly by using an insulation substrate 80 whose Young's modulus is 55 to 440Gpa as the insulation substrate constituting the interposer 70, stress is absorbed within the interposer 70.

## Description

### BACKGROUND OF THE INVENTION

The present invention relates to an interposer and a multilayer printed wiring board and more particularly to an interposer to be located between a package substrate made of resin and an IC chip made of ceramic and a multilayer printed wiring board equipped with an interposer for connecting the IC chip.

The package substrate is used to connect the IC chip at a fine pitch to an external substrate such as daughter board. As material of the package substrate, ceramic or resin is used. Because the ceramic package substrate utilizes metallized wiring obtained by baking, its resistance rises and dielectric constant of ceramic is high, and therefore, it is difficult to load a high frequency, high performance IC thereon. On the other hand, the resin made package substrate allows its wiring resistance to be lowered because it utilizes copper wiring by plating and further, because dielectric constant of resin is low, loading of a high frequency, high performance IC is relatively easy.

As technologies for placing the interposer between the package substrate and the IC chip, patent documents 1-4 are available.
Prior Art: JP 2001-102479 A
Prior Art: JP 2002-373962 A
Prior Art: JP 2002-261204 A
Prior Art: JP 2000-332168 A

If the frequency of the IC exceeds 3GHz, malfunction occurs unless resin of the wiring layer of the IC is turned to have low dielectric constant. To secure low dielectric constant, usually, resin of the wiring layer is made to contain air bubbles. If it contains air bubbles, the resin becomes brittle. If an IC whose wiring layer is formed of such brittle resin is loaded, crevice or breaking is generated in the resin layer of the IC due to thermal stress when it is loaded on a substrate, etc.

### SUMMARY OF THE INVENTION

The present invention has been achieved to solve the above-mentioned problem and therefore, an object of the invention is to provide an interposer capable of preventing generation of cracks due to thermal expansion or thermal contraction and supplying electricity to electronic components such as the IC chip stably and a multilayer printed wiring board equipped with the interposer.

As a result of accumulated researches for achieving the above-mentioned object, the inventor of the present invention and other people have reached an idea of locating an interposer for connecting a package substrate made of resin and an IC chip made of ceramic electrically.

The insulation base material constituting the interposer is preferred to have a Young's modulus of 55 to 440GPa and its thickness is preferred to be in a following relationship.

The relation of thickness of package substrate x 0.05≤ thickness of insulation base material s thickness of package substrate x 1.5, further thickness of package substrate x 0.1 s thickness of insulation base material ≤ thickness of package board x 1. 0 is preferable. The package substrate mentioned here refers to a resin made package substrate in which interlayer insulation layer and conductor circuit are laminated on a single surface or both surfaces of a core substrate described later.

The inventor analyzed thermal stress at the time of loading the substrate of a semiconductor device (3D strip simulation: with compositions of interposer, interposer through hole conductor, IC chip, package substrate, solder for joining the interposer with the IC chip or interposer with the package substrate and the like set the same, their Young's modulus, Poisson ratio, thermal expansion coefficient and thickness were inputted for calculation) . At this time, if the Young's modulus of the insulation base material constituting the interposer is within the aforementioned range, the amount of each deformation of the IC chip, interposer and resin made package substrate to changes in temperature gets into the relation of IC≤interposer<<package substrate. Because the interposer is difficult to deform even if the amount of deformation of the resin made package is large relative to the amount of deformation of the IC by locating the interposer having the Young's modulus in the above-mentioned range between the IC and the resin made package substrate, thermal stress originating from a difference in thermal expansion between the IC and the resin package becomes difficult to transmit to the resin layer of the IC. Thus, to prevent the IC resin from being destroyed, it is effective to locate an interposer having a high Young's modulus between the IC and the package substrate.

If the Young's modulus of the insulation base material constituting the interposer is less than 55GPa, the amount of deformation of the interposer increases when the interposer is located between the package substrate and the IC chip because the Young's modulus is low, so that stress reaches resin of the wiring layer of the IC. On the other hand, if it exceeds 440GPa, stress concentrates on solder bump between the interposer and the package substrate, so that crevice or breaking occurs at that place.

The interposer is so constructed to connect an external electrode of the IC with the connection pad of the resin made package substrate electrically and directly via the through hole conductor. The through hole conductor is formed of conductive material having a low Young's modulus as compared with the insulation base material constituting the interposer. Thus, in the insulation base material constituting the interposer, the Young's modulus and thermal expansion coefficient differ between at a portion just below the IC and at the other portions. Thus, the insulation base material constituting the interposer is likely to warp with a portion just below the periphery of the IC as a starting point. Because the amount of warp depends on the thickness, if the thickness of the insulation base material constituting the interposer becomes less than thickness of the resin made package substrate x 0.05, the amounts of the deformation and warpage increase because of such a small thickness even if the Young's modulus of the insulation base material constituting the interposer is in the range of 55 to 440GPa. As a result, it comes that the IC receives a force of pulling outward or a bending force, crevice or breaking occurs in the resin of the wiring layer of the IC.

If the Young's modulus of the insulation base material constituting the interposer is in the range of 55 to 440GPa and the thickness reaches thickness of resin made package substrate x 0.05 or more, the stiffness of the insulation base material constituting the interposer increases because of such a thickness. For the reason, the deformation and warpage generated because the physical property differ between a portion just below the IC and the other portions of the insulation base material constituting the interposer decreases. Therefore, the amounts of IC's deformation and warpage with the interposer decrease, so that no crevice or breaking occurs in the resin of the wiring layer of the IC.

The thickness of the insulation material constituting the interposer is preferred to be over thickness of core of package substrate x 0.08. The reason is that the deformation of the package substrate depends on the core substrate because the package substrate is composed of mainly the core substrate.

On the other hand, if the thickness of the interposer exceeds thickness of package substrate x 1.5, the interposer is not warped. As a result, stress originating from a difference in thermal expansion coefficient between the IC and the interposer is not relaxed in Z direction but concentrates in X-Y direction (the X-Y direction mentioned here means a direction parallel to the surface of the interposer) and crevice or breaking occurs in the resin of the wiring layer of the IC. Further, a demand for thinning is not met because the entire semiconductor device thickens. As other reason, thickening of the insulation base material is not suitable for formation into a fine structure because a small diameter through hole cannot be formed easily.

Although material of the insulation base material constituting the interposer is not restricted to any particular one if its Young's modulus is 55 to 440GPa, for example, glass substrate such as pyrex glass, SF₂ glass, BK7 glass, MGF₂ glass, ceramic substrate such as zirnonia, aluminum nitride, silicon nitride, silicon carbide, alumina, mulite, codierite, stirtite, LTCC substrate (low temperature baked ceramic substrate), forsterite, substrate obtained by impregnating core material like glass cloth with olefin resin, epoxy resin, polyimide resin, phenol resin and BT resin and other thermoplastic resin, substrate in which inorganic filler is dispersed, such as glass filler, alumina and zirconia can be mentioned.

Of these, as a starting material of the interposer, it is preferable to use baked ceramic substrate or glass substrate. Because there is no high temperature treatment which induces contraction or change in dimension after the through holes are formed, the position accuracy of the through hole can be raised. Further, if glass component contained ceramic substrate such as pyrex glass, mulite, cordierite, stirtite, forsterite is used for the interposer, it is advantageous when transmitting a high-speed signal because their dielectric constants are low.

Although solder material for use in a joint portion between an electronic component such as the IC and the interposer or interposer and package is not restricted to any particular one, for example, Sn/Pb, Sn/Ag, Sn, Sn/Cu, Sn/Sb, Sn/In/Ag, Sn/Bi, Sn/In, copper paste, silver paste, conductive resin and the like can be mentioned.

The size of the insulation base material constituting the interposer is preferred to have a following relation.

The preferred relation is projection area of electronic component to be loaded on the interposer ≤ area of insulation base material constituting the interposer ≤ projection area of package substrate x 1, and further, projection area of electronic component x 1.2 ≤ area of insulation base material constituting the interposer ≤ projection area of package substrate x 0.8.

The reason is that if the area of the insulation base material constituting the interposer is less than the projection area of an electronic component, the electronic component cannot be loaded on the interposer. If the area of the insulation base material constituting the interposer is equal to or over the projection area of the electronic component x 1.2, mold resin can be charged between the interposer and the electronic component because there is generated a step therebetween. The service lives of a joint portion and electronic component to thermal shock are extended because the mold resin can relax stress. If the area of the insulation base material constituting the interposer is equal to or below 0.8 times the projection area of the package substrate, the mold resin can be charged between the interposer and package main body because a step is generated therebetween. By charging the mold resin between the both, the reliability of the entire semiconductor device to thermal shock is improved. Then, if the size of the insulation base material constituting the interposer exceeds the projection area of the package substrate, the demand for reduction of the size is not met because the entire size of the substrate increases. If the interposer is enlarged, the insulation layer of the IC is likely to be destroyed because the amount of deformation to changes in temperature increases.

Preferably, the insulation base material constituting the interposer has a Young's modulus of 55 to 440GPa and a thickness which is 0.05 times or more to 1.5 times or less the thickness of the package substrate and includes a through hole in which the through hole conductor for connecting the front and rear surfaces electrically is formed. The arrangement of the through holes connected to the power source and ground terminal of the IC is preferred to be in the form of a grid or in a staggered fashion. The pitch is preferred to be 60 to 250µm, and more preferred to be 180µm or less.

The through hole may be filled with conductive material or covered with plating or the like while its non-filled portion may be filled with insulation agent or conductive material. Although the conductive material to be charged in the through hole is not restricted to any particular one, preferably it is filled with single metal such as copper, gold, silver, nickel and the like or two or more kinds of metals rather than conductive paste or metal paste. The reason is that supply of power to the IC is executed smoothly or the amount of generated heat decreases because resistance is lower as compared with conductive paste. The other reason is that stress is absorbed due to plastic deformation of metal because the inside of the through hole is filled with metal completely.

If the through holes in the insulation base material constituting the interposer are disposed in the form of a grid or in a staggered fashion and the pitch of the through holes is 250µm or less, inductance decreases so that the supply of power to the IC is executed smoothly, because a distance between adjoining through holes decreases. As for the through hole conductor connected to the power source terminal of the IC, preferably, a through hole conductor connected to the ground terminal of the IC is disposed at an adjacent position. As for the through hole conductor connected to the ground terminal of the IC, preferably, a through hole conductor connected to the power source terminal of the IC is disposed at an adjacent position. The reason why the pitch of the through holes should be 250µm or less is that the diameter of the through hole decreases if it is intended to decrease the pitch of the through holes. If the diameter of the through hole decreases, the diameter of the conductive material charged in the through hole decreases. As a result, conductive material becomes easy to deform due to generated stress, so that relaxing of stress is enabled with even the conductive material. The diameter is preferred to be 30 to 150µm or less. If it is less than 30µm, the strength of the conductive material in the through hole vanishes so that the conductive material is destroyed due to fatigue. On the other hand, if it exceeds 150µm, the conductive material or the insulation base material is destroyed due to fatigue because a difference between expansion and contraction of conductive material and insulation substrate at the time of temperature changes increases. If the diameter of the through hole is 125µm or less, it is effective that the through holes connected to the power source terminal and ground terminal of the IC are disposed in the form of a grid or in the staggered fashion. The reason is that the amount of heat generation increases in the through holes connected to the power source and ground terminal of the IC because conductor resistance increases. If the through holes are disposed in the form of a grid or in the staggered fashion, they are disposed uniformly. Thus, the temperature distribution of the interposer at the time of usage becomes uniform so that no stress concentrates on any specific location thereby the insulation layer of the IC chip being not damaged. Further, the physical property (thermal expansion coefficient, Young's modulus and the like) of the insulation base material just below the IC chip becomes uniform because the through holes are formed uniformly.

As regards the sectional shape of a through hole in the insulation base material, preferably, the diameter of an opening in at least an end face is equal to or larger than the diameter of a hole in the center of the through hole. Further, the relation of the diameter of opening in an end face/diameter of a minimum hole of the through hole is preferred to be 1.02 to 5.0. If it is less than 1, it is difficult to fill the through hole with conductive material without any non-filling. If it is 1.02 or more, the conductive material is charged easily because the diameter of the opening in the end face of the through hole is larger than the other through hole portions. As a result, void is difficult to generate in the conductive material. Because void is difficult to generate, conduction resistance of the entire conductor drops and no Joule heat is generated in the vicinity of the void, so that the supply of power to the IC is executed smoothly and malfunction in a high frequency region exceeding 3GHz is diminished. Because the shape of the through hole is tapered, generated stress reaches a joint portion along the shape of the through hole. Consequently, stress is not transmitted directly to the joint portion but is dispersed. From this viewpoint, it is more advantageous that the diameter of the opening in at least an end face of the interposer is larger than the diameter of the hole in the center of the through hole. Further, it is better if the diameter of the opening on each of both end faces is larger than the diameter of the opening in the center. On the other hand, if the diameter of opening in an end face/the minimum diameter of the through hole exceeds 5, the diameter of the land increases or the diameter of the opening in the center decreases. The former is not suitable for formation into fine structure or the size of the interposer is enlarged. Because the size thereof is enlarged, stress increases correspondingly so that the insulation layer of the IC becomes easy to destroy. In the latter case, conductive material becomes easy to break at the minimum diameter portion. To increase the diameter of the opening in an end face as compared with the diameter of the hole in the center of the through hole, for example, the quantity of laser shots is decreased as compared with a case where an opening is made straight. Making the diameter of the openings in both end faces larger than in the center of the through hole is made possible by making an opening from both the end faces with laser or blast.

### BRIEF DESCRIPTION OF THE DRAWINGS

FIG. 1 is a sectional view of a resin made package substrate according to a first example of the present invention;
FIG. 2 is a sectional view showing a condition in which an interposer is mounted on the resin made package substrate shown in FIG. 1;
FIG. 3 is a sectional view showing a condition in which the resin made package substrate shown in FIG. 2, loaded with an IC chip, is mounted on a daughter board;
FIG. 4 is a plan view of IC chip, interposer and resin made package substrate shown in FIG. 3;
FIG. 5(A) is a plan view of an interposer of the first example and FIG. 5 (B) is a plan view of an interposer according to another example of the first example;
FIG. 6 is a manufacturing process diagram of the interposer according to the first example;
FIG. 7 is a manufacturing process diagram of the interposer according to a seventh example;
FIG. 8 is a manufacturing process diagram of the interposer according to the seventh example;
FIG. 9 is a manufacturing process diagram of the interposer according to a 22nd example;
FIG. 10 is a manufacturing process diagram of the interposer according to a 41st example;
FIG. 11 is a manufacturing process diagram of the interposer according to the 41st example;
FIG. 12 is a diagram showing a result of heat cycle test;
FIG. 13 is a diagram showing a result of heat cycle test;
FIG. 14 is a diagram showing a result of heat cycle test;
FIG. 15 is a diagram showing stress applied to resin of IC wiring layer; and
FIG. 16 (A) is a schematic diagram of an insulating base material (interposer) and FIG. 16(B) is a diagram showing Young's modulus of a portion just below the IC and other portions of the insulating base material (interposer).

### BEST MODE FOR CARRYING OUT THE INVENTION

### [Examples]

### 1. Resin made package substrate

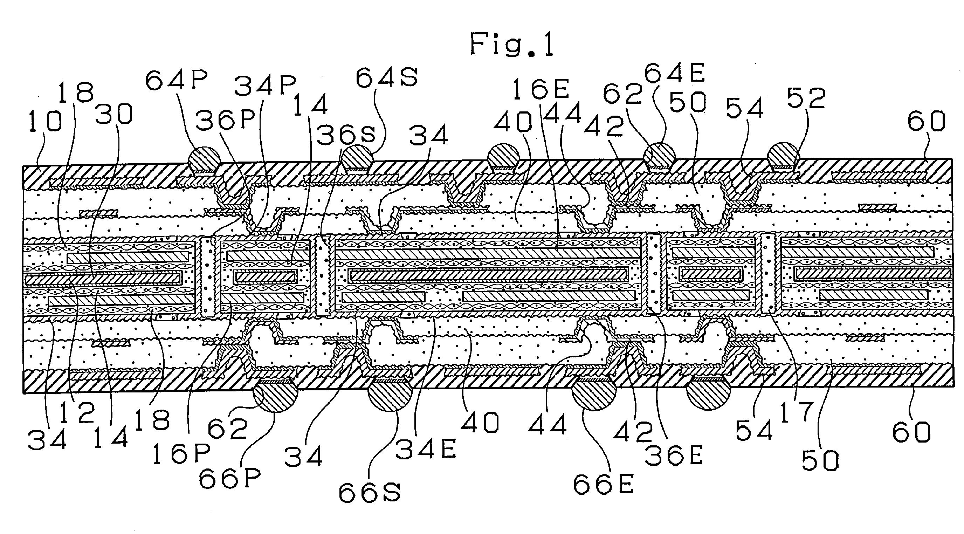

The structure of the resin made package substrate 10 will be described with reference to FIG. 1 showing a sectional view of the resin package substrate 10 according to the first example. The resin made package substrate 10 utilizes a multilayer core substrate 30. A conductor circuit 34 and conductive layer 34P are formed on the front surface side of the multilayer core substrate 30 and a conductor circuit 34 and conductive layer 34E are formed on the rear surface. The conductive layer 34P on the upper side is formed as a plain layer for power source and the conductive layer 34E on the lower side is formed as a plain layer for grounding. Further, a conductive layer 16E of an inner layer is formed on the upper face side inside the multilayer core substrate 30 and a conductive layer 16P is formed on the lower face side. The conductive-layer 16E on the upper side is formed as a plain layer for grounding and the conductive layer 16P on the lower side is formed as a plain layer for power source. The plain layer 34P for power source and the plain layer 16P are connected through a power source through hole 36P. The plain layer 34E for grounding and the plain layer 16E are connected through a grounding through hole 36E. Connection of signals between up and down of the multilayer core substrate 30 is carried out through a signal through hole 365. The plain layer may be of single layer located on only one side or may be composed of two or more layers. It is preferred to be formed of two to four layers. Because no improvement of electric characteristic has been confirmed in more than four layers, substantially the same effect as in case of four layers is provided if multi-layers more than four layers are laid. The reason why it is constructed of two layers is that elongations of the substrate are arranged neatly for matching of stiffness of the multilayer core substrate so that warpage is difficult to cause. A metal plate 12 isolated electrically is accommodated in the center of the multilayer core substrate 30 (the metal plate 12 is composed of low thermal expansion coefficient metal such as invar, 42 alloy, acting as a core material and not connected electrically to any through hole or via hole. This mainly acts for lowering the thermal expansion coefficient of the substrate and improving the stiffness to warpage. As for its location, it may be disposed over an entire substrate or may be disposed like a frame below the surrounding of a loaded IC). With respect to the metal plate 12, the conductive layer 16E of the inner layer is formed on the upper face side via insulation resin layer 14 and the conductive layer 16P is formed on the lower side. Further, conductor circuit 34 and conductive layer 34P are formed on the upper side via insulating resin layer 18 and conductor circuit 34 and conductive layer 34E are formed on the lower side.

Interlayer resin insulating layer 40 in which via hole 44 and conductor circuit 42 are formed and interlayer resin insulating layer 50 in which via hole 54 and conductor circuit 52 are formed, are formed on the conductive layers 34P, 34E on the front surface of the multilayer core substrate 30. Solder resist layer 60 is formed on the via hole 54 and conductor circuit 52 and signal bump 64S, power source bump 64P and ground bump 64E are formed in the via hole 54 and conductor circuit 52 on the upper face side via an opening portion 62 in the solder resist layer 60. Likewise, signal external terminal 66S, power source external terminal 66P and ground external terminal 66E are formed in the via hole 54 and the conductor circuit 52 on the lower face side.

The through holes 36E, 36P, 36S are produced by forming through hole conductive layer in the core substrate 30 and filling that vacancy with insulating resin 17. The through holes may be filled completely with conductive paste or plating.

The conductive layers 34P, 34E on the front layer of the core substrate 30 is formed in the thickness of 5 to 35µm, the conductive layers 16P, 16E in the inner layer are formed in the thickness of 5 to 250µm and the conductor circuit 42 on the interlayer resin insulating layer 40 and the conductor circuit 52 on the interlayer resin insulating layer 50 are formed in the thickness of 5 to 25µm.

In the resin made package substrate of this example, the power source layer (conductive layer) 34P and conductive layer 34 on the front layer of the core substrate 30, and the power source layer (conductive layer) 16P and the conductive layer 16E in the inner layer and the metal plate 12 are formed thick. As a consequence, the strength of the core substrate is intensified. Therefore, even if the core substrate itself is thinned, warpage and generated stress can be relaxed by the substrate itself.

By thickening the conductive layers 34P, 34E and the conductive layers 16P, 16E, the volume of conductor itself can be increased. Due to the increase in volume, resistance of the conductor can be decreased.

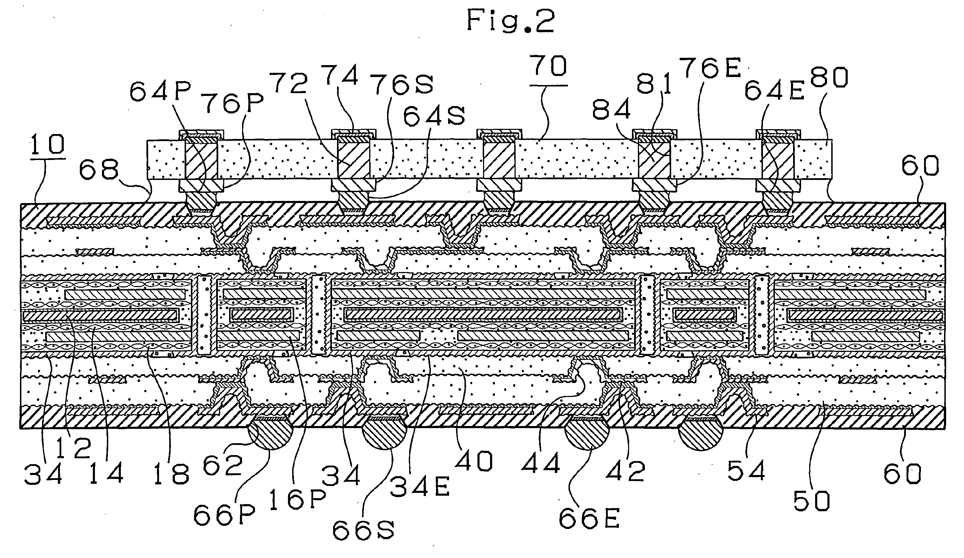

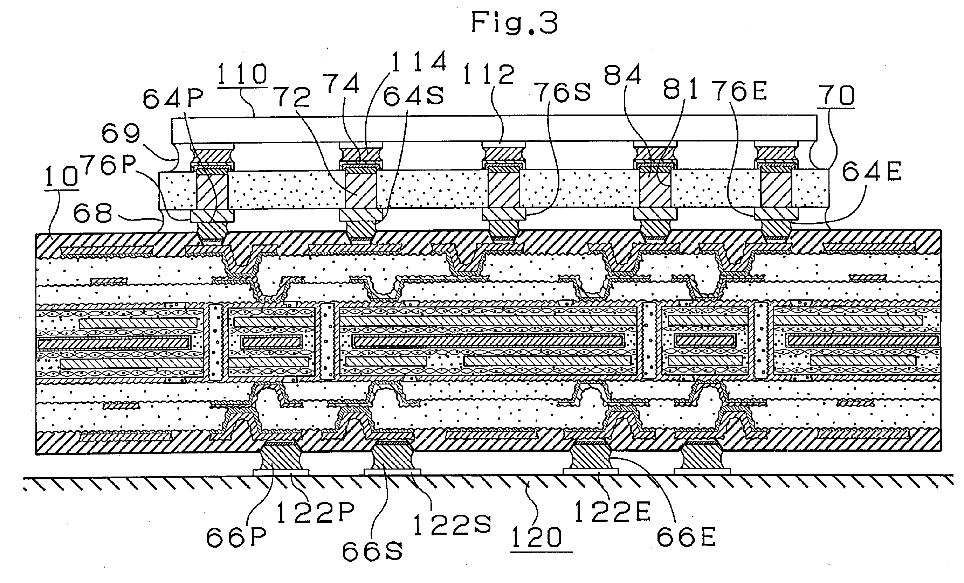

FIG. 2 is a sectional view showing a condition in which an interposer 70 is mounted on the resin made package substrate 10 and FIG. 3 is a sectional view showing a condition in which an IC chip 110 is mounted on the interposer 70 and the resin made package substrate 10 is loaded on a daughter board 120. The interposer 70 is constructed by disposing land 74 on the upper face of a via hole 72 produced by filling a through hole 81 in insulating base material 80 with conductive substance 84 and further, power source land 76P, signal land 76S and ground land 76E on the lower face thereof. Resin made under-fill 68 is loaded between the resin made package substrate 10 and the interposer 70. A land 112 of an IC chip 110 is connected to the land 74 on the upper face side of the interposer 70 via solder 114. Resin made under-fill 69 is loaded between the interposer 70 and the IC chip 110.

The signal land 76S, the power source land 76P and the ground land 76E of the interposer 70 are connected to the signal bump 64S, the power source bump 64P and ground bump 64E on the upper face side of the resin made package substrate 10. On the other hand, the signal external terminal 66S, the power source external terminal 66P and the ground external terminal 66E on the lower side of the resin made package substrate 10 are connected to signal land 122S, power source land 122P and ground land 122E of the daughter board 120. The external terminal in this case refers to PGA, BGA, solder bump and the like.

In the resin made package substrate 10 of the first example, the capacity for supply of power to the IC chip 110 can be improved by using the conductive layers 34P, 16P as power source layers. For the reason, when the IC chip 110 is mounted on the package substrate 10, loop inductance from the IC chip 110 to the substrate 10 to the power source on the side of the daughter board 120 can be reduced. As a consequence, shortage of power at the time of the initial operation decreases and thus, the shortage of power becomes difficult to occur, so that even if an IC chip for high frequency area is mounted, no malfunction or error is induced at the initial startup. Further, by using the conductive layers 34E, 16E as ground layer, any noise comes not to overlap signal and supply of power to the IC chip, thereby preventing malfunction or error. Further, by loading a capacitor (not shown), the shortage of power becomes difficult to occur because power accumulated in the capacitor can be consumed as supplement.

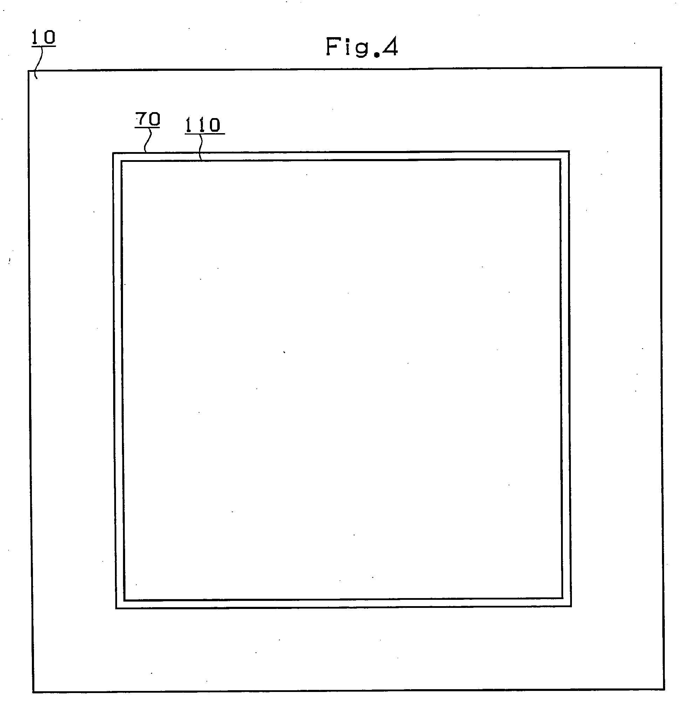

FIG. 4 shows a plan view of the IC chip 110, interposer 70 and resin made package substrate 10 of FIG. 3. The dimension of the external shape of the resin made package substrate is 40mm x 40mm and its thickness is 1.0mm. The thickness of the core substrate is 0.8mm. The dimension of the external shape of the insulating base material 70 constituting the interposer is 28mm x 28mm, its thickness is 100µm and the dimensions of the external shape of the IC chip 110 is 20mm x 20mm.

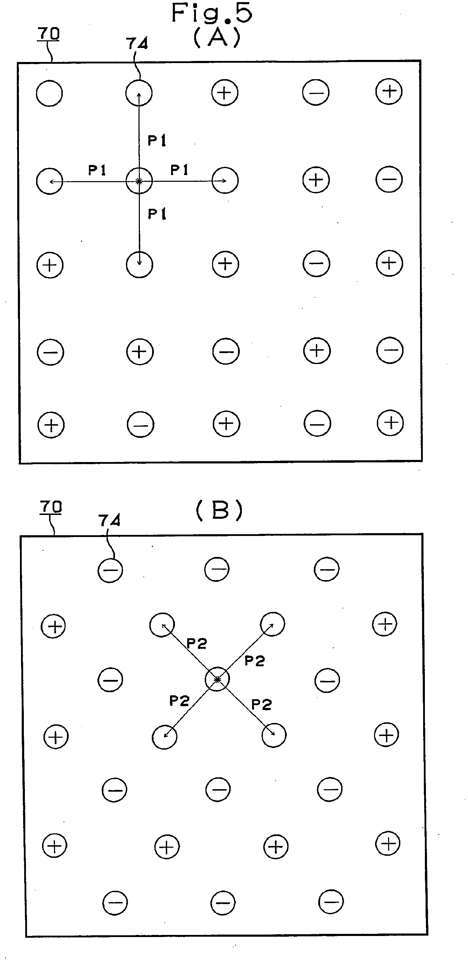

FIG. 5(A) shows a plan view of part of the interposer 70. This shows part of through holes connected to the power source terminal and ground terminal of the IC. The lands 74 (through hole 81) of the interposer are disposed in the form of a grid and the pitch P1 is set to, for example, 175µm. FIG. 5(B) shows a plan view of the interposer according to other example. The lands 74 (through hole 81) of the interposer are disposed in a staggered fashion and its pitch P2 is set to, for example, 120µm. + indicates a through hole connected to a power source terminal of the IC and - indicates a through hole connected to a ground terminal of the IC.

According to the first example, when the IC chip 110 is coupled with the package substrate 10, stress disperses to two places, a joint portion (solder 114) between the IC chip 110 and the interposer 70 and a joint portion (signal bump 64S, power source bump 64P, ground bump 64E) between the interposer 110 and the package substrate 10, because the interposer 70 exists. Further, because the interposer 70 having Young's modulus of 55 Gpa and which is 0.05 times as thick as the package board exists, the interposer 70 receives stress due to a difference in thermal expansion between the ceramic made IC chip 110 and the resin made package substrate 10, so that no stress is transmitted to resin in the wiring layer of the IC chip 110. As a result, no crevice or breaking occurs in resin of the wiring layer of the IC chip.

### 2. Manufacturing of interposer

### [First example] Young's modulus = 55 GPa, dimension of external shape = 32mm x 32mm, thickness of interposer = 50µm

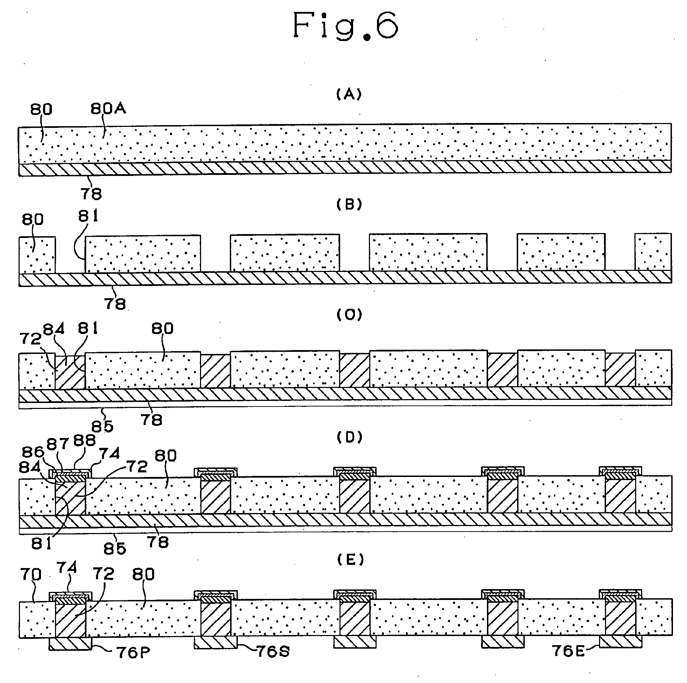

The manufacturing process of the interposer of the first example will be described with reference to FIG. 6.
(1) 100 weight part of bisphenol A type epoxy resin, 5 weight part of imidazole type hardening agent and 60 weight part of alumina filler were mixed and that resin was impregnated into glass cloth and dried to obtain prepreg 80 as B stage. Hardened single face copper clad laminate 80A obtained by laminating the prepreg 80 and copper foil 78 and then pressing with heat under pressure was used as a starting material (FIG. 6(A)). The thickness of this insulating base material 80 is 50µm and the thickness of the copper foil 78 is 12µm. The Young's modulus of the insulating substrate constituting this interposer was 55GPa when measured according to three-point-bending method based on JIS. In the meantime, for this measurement of Young's modulus, an insulating base material 1 mm thick was used.
(2) Next, by irradiating with carbon dioxide gas laser from the side of an insulation material side according to condition of Table 1, the insulation base material 80 was holed so as to form a via hole formation opening 81 leading to the copper foil 78 and further, the inside of the opening 81 was subjected to de-smear treatment by irradiating with ultraviolet laser (FIG. 6(B)). According to this first example, in formation of an opening for via hole formation, a high peak short pulse oscillation type carbon dioxide gas laser processing unit manufactured by MITSUBISHI ELECTRIC CORPORATION was used and laser beam was irradiated to a glass cloth epoxy resin base material 50µm thick from the side of the insulation material according to mask image method so as to form an opening for via hole formation 125µm at a speed of 100 holes per second. As for the disposition, they were formed at a pitch of 180µm at positions corresponding to the external electrode of the IC one to one. In the meantime, the power source and ground terminal of the Id are in the form of a grid. After the via holes were formed, de-smear treatment was carried out. As a ultraviolet laser irradiating unit using YAG third harmonic for the de-smear treatment, GT605LDX manufactured by MITSUBISHI ELECTRIC CORPORATION was used and laser irradiation condition for the de-smear treatment was 5 KHz in oscillation frequency, 0.8mJ in pulse energy and 10 in shot count.

**[Table 1]**

| | |
|---|---|
| Mask diameter | F1.4mm |
| Pulse energy | 2.0mj/pulse |
| Shot count | 7 shots |

(3) After copper foil was protected with PET film 85, electrolytic copper plating treatment was carried out to a substrate subjected to desmear treatment with the copper foil 78 as plating lead with following plating solution under following condition to form a via hole 72 by filling the opening 81 with electrolytic copper plating 84 with a slight gap left on top of the opening 81 (FIG. 6 (C)).
[Electrolytic plating solution]
Sulfuric acid: 2.24 mol/l
Copper sulfate: 0.26 mol/l
Additive: 19.5 ml/l (manufactured by ATOTECH JAPAN, KAPARACID GL)
[Electrolytic plating condition]
Current density: 6.5 A/dm²
Time: 30 minutes
Temperature: 22±2°C
(4) Further, by dipping in electroless nickel plating solution at pH = 5, composed of nickel chloride 30g/l, sodium hypophosphite 10g/l, and sodium citrate 10g/l for 20 minutes, nickel plating layer 86 5µm thick was formed on the copper plating 84. That substrate was dipped in electroless gold plating solution composed of gold potassium cyanide 2g/l, ammonium chloride 75g/l, sodium citrate 50g/l, and sodium hypophosphite 10g/l for 23 seconds at 93°C so as to form gold plating layer 87 0.03µm thick on the nickel plating layer. After the gold plating 87 was applied, tinning 88 was deposited in the thickness of 30µm on the gold plating layer 87 with following plating solution and condition so as to form the land 74 (FIG. 6(D)). The tinning 88 may be omitted.
[Electrolytic plating solution]
Sulfuric acid: 105ml/l
Tin sulfate: 30g/l
Additive: 40 ml/l
[Electrolytic plating condition]
Current density: 5A/dm²
Time: 45 minutes
Temperature: 22±2°C
(5) After that, the PET film 85 was peeled from the copper plating 78 and dry film was adhered to the copper foil 78 and after exposure and development, the copper foil 78 was subjected to etching treatment with alkaline etching liquid so as to form the lands 76P, 76S, 76E.
(6) Finally, its external shape was processed to 32mm x 32 mm to obtain an interposer.

### [Second example] Young's modulus = 55 GPa, dimensions of external shape = 32mm x 32mm, thickness of interposer = 64µm

For the interposer of the second example, the thickness of the substrate of a starting material in the first example was set to 64µm. Accompanied by that, laser condition for forming a through hole was changed to condition shown in the following table. Plating time for filling the through hole with conductive agent was changed corresponding to the thickness of the substrate. The other conditions were the same as the first example.

**[Table 2] Laser condition**

| | |
|---|---|
| Mask diameter | F1.4mm |
| Pulse energy | 2.0mj/pulse |
| Shot count | 9 shots |

### [Third example] Young's modulus = 55 GPa, dimensions of external shape = 32mm x 32mm, thickness of interposer = 100µm

For the interposer of the third example, the thickness of the substrate of a starting material in the first example was set to 100µm. Accompanied by that, laser condition for forming a through hole was changed to condition shown in the following table. Plating time for filling the through hole with conductive agent was changed corresponding to the thickness of the substrate. The other conditions were the same as the first example.

**[Table 3] Laser condition**

| | |
|---|---|
| Mask diameter | F1.4mm |
| Pulse energy | 2.0mj/pulse |
| Shot count | 14 shots |

### [Fourth example] Young's modulus = 55 GPa, dimensions of external shape = 32mm x 32mm, thickness of interposer = 400µm

For the interposer of the fourth example, the thickness of the substrate of a starting material in the first example was set to 400µm. Accompanied by that, laser condition for forming a through hole was changed to condition shown in a following table. Plating time for filling the through hole with conductive agent was changed corresponding to the thickness of the substrate. The other conditions were the same as the first example.

**[Table 4] Laser condition**

| | |
|---|---|
| Mask diameter | F1.4mm |
| Pulse energy | 2.0mj/pulse |
| Shot count | 60 shots |

### [Fifth example] Young's modulus = 55 GPa, dimensions of external shape = 32mm x 32mm, thickness of interposer = 1000µm

For the interposer of the fifth example, the thickness of the substrate of a starting material in the first example was set to 1000µm. Accompanied by that, laser condition for forming a through hole was changed to condition shown in the following table. Plating time for filling the through hole with conductive agent was changed corresponding to the thickness of the substrate. The other conditions were the same as the first example.

**[Table 5] Laser condition**

| | |
|---|---|
| Mask diameter | F1.4mm |
| Pulse energy | 2.0mj/pulse |
| Shot count | 150 shots |

### [Sixth example] Young's modulus = 55 GPa, dimensions of external shape = 32mm x 32mm, thickness of interposer = 1500µm

For the interposer of the sixth example, the thickness of the substrate of a starting material in the first example was set to 1500µm. Accompanied by that, laser condition for forming a through hole was changed to condition shown in the following table. Plating time for filling the through hole with conductive agent was changed corresponding to the thickness of the substrate. The other conditions were the same as the first example.

**[Table 6] Laser condition**

| | |
|---|---|
| Mask diameter | F1.4mm |
| Pulse energy | 2.0mj/pulse |
| Shot count | 230 shots |

### [Seventh example] Young's modulus = 200 GPa, dimensions of external shape = 32mm x 32mm, thickness of interposer = 50µm

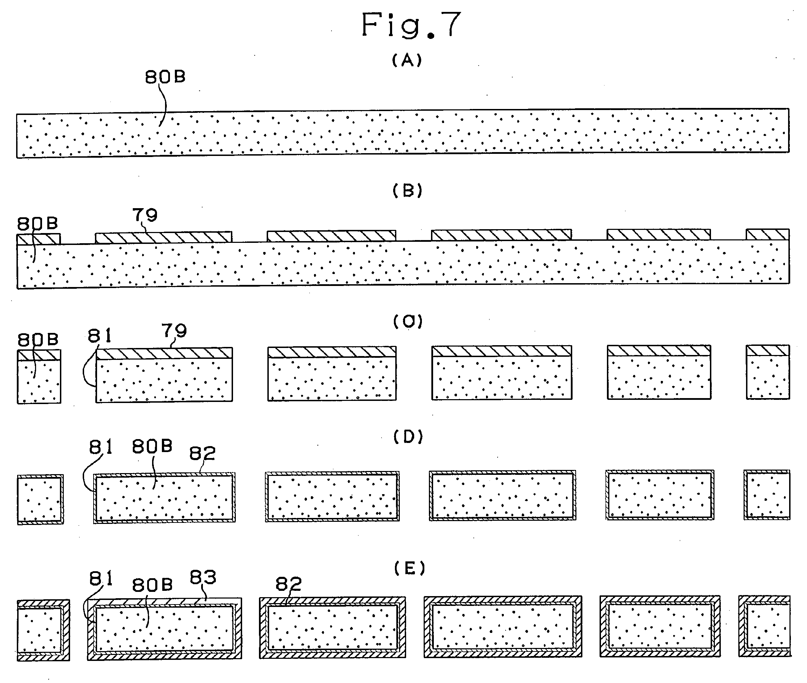

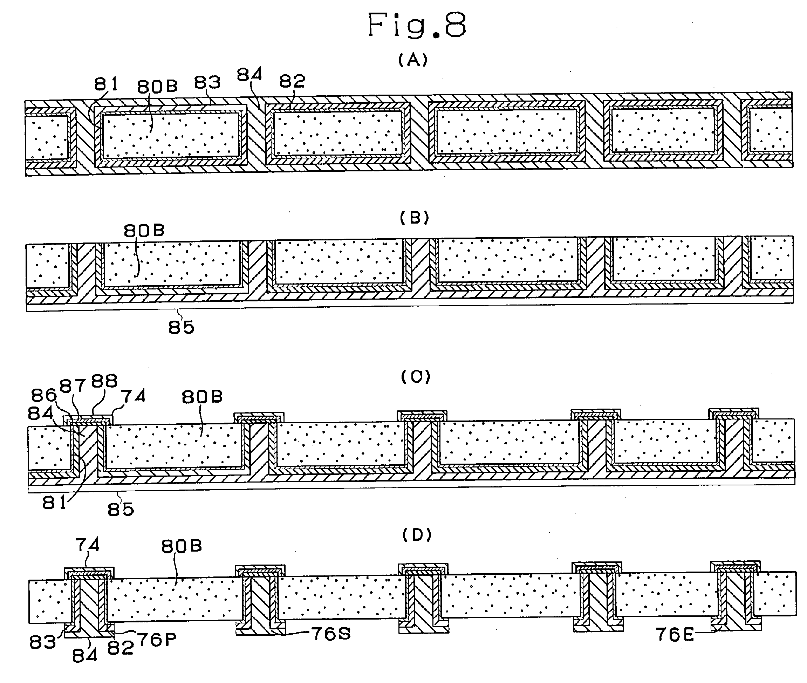

The manufacturing method of the interposer according to the seventh example will be described with reference to FIGS. 7, 8.
(1) A baked zirconia (manufactured by HIPPON FINE CERAMICS CO., LTD.) 80B, 32mm x 32mm x 50µm in thickness was used as a starting material (FIG. 7(A)). The Young's modulus of this insulation substrate was 200 GPa when measured according to three-point-bending method based on JIS. For the measurement of Young's modulus, insulation base material 1mm thick was used. Urethane base resist 79 was adhered to a face of this substrate 80B and an opening 81a 125µm in diameter was formed at a position corresponding to the external electrode of the IC according to ordinary photography method (FIG. 7(B)).
(2) Next, sand blast treatment was carried out from a side in which the resist 79 was formed, by using a sand blast unit manufactured by SHINTOBRATOR, LTD. under a following condition so as to form an opening 81 for via hole formation, 125µm. As for the disposition, they were formed at a pitch of 180 µm at positions corresponding to the external electrodes of the IC one to one (FIG. 7(C)). The power source and ground terminals of the IC were disposed in the form of a grid. After that, the resist 79 was peeled.

**[Table 7] Sand blast condition**

| | |
|---|---|
| Grain | Synthetic diamond |
| Grain diameter | Average grain diameter 25µm |
| Pressure | 0.2MPa |
| Number of shots | 7 |

(3) Chrome film 0.1µm thick was formed by sputtering on the entire surface of a substrate in which the openings 81 for via hole formation were formed and then, nickel film (chrome film and nickel film are represented by film 82) 0.14pm thick was deposited on that chrome film by evaporation (FIG. 7(D)).
(4) Next, a substrate was dipped in electroless copper plating solution having the following composition so as to form electroless copper plating film 83 0.6 to 3.0 µm thick on the nickel film (FIG. 7 (E)).
[Electroless plating solution]
200 mol/l copper sulfate
0.800 mol/1EDTA
0.030 mol/1HCHO
050mol/1NaOH
100 mol/lα, α' - bipyridyl
100 mg/l polyethylene glycols (PEG) 0.10 g/l
[electroless plating condition]
40 minutes at a liquid temperature of 34°C
(4) Next, using plating solution deposited preferentially in the through hole 81 on the electroless copper plating film 83, the through holes 81 were filled and electrolytic copper plating 84 was formed on the surface of the base material 80B (FIG. 8(A)).
[Electrolytic plating solution]
sulfuric acid: 150g/l
copper sulfate: 160g/l
additive: 19.5 ml/l
[Electrolytic plating condition]
current density: 6.5 A/dm²
time: 80 minutes
temperature: 22± 2°
agitation: agitation by jet
(5) After that, one face of the substrate 80B was protected with PET film 85 and only the other face was polished until the surface of the base material 80B was exposed (FIG. 8(B)).
(6) After plating of nickel 86 (5µm) and gold plating 87 (0.03µm) were applied on the copper plating 84 in the through hole 81, tin plating (the same condition as the first example) 88 was deposited in the thickness of 30µm with copper on the other face used as lead so as to form the land 74 (FIG. 8(C)). The tin plating 88 may be omitted.
(7) After that, the PET film 85 was peeled and dry film was pasted on the electric copper 84 located under the PET film 85. After exposure and development, the electric copper plating layer and electroless copper plating layer were subjected to etching treatment with alkaline etching liquid so as to form the lands 76P, 76S, 76E (FIG. 8(D)).

### [Eighth example] Young's modulus = 200 GPa, dimensions of external shape = 32mm x 32mm, thickness of interposer = 64µm

For the interposer of the eighth example, the thickness of the substrate of a starting material in the seventh example was set to 64µm. Accompanied by that, sand blast condition for forming a through hole was changed to condition shown in the following table. Plating time for filling the through hole with conductive agent was changed corresponding to the thickness of the substrate. The other conditions were the same as the seventh example.

**[Table 8] Sand blast condition**

| | |
|---|---|
| Grain | Synthetic diamond |
| Grain diameter | Average grain diameter 25µm |
| Pressure | 0.2MPa |
| Number of shots | 9 |

### [Ninth example] Young's modulus = 200 GPa, dimensions of external shape = 32mm x 32mm, thickness of interposer = 100µm

For the interposer of the ninth example, the thickness of the substrate of a starting material in the seventh example was set to 100µm. Accompanied by that, sand blast condition for forming a through hole was changed to condition shown in the following table. Plating time for filling the through hole with conductive agent was changed corresponding to the thickness of the substrate. The other conditions were the same as the seventh example.

**[Table 9] Sand blast condition**

| | |
|---|---|
| Grain | Synthetic diamond |
| Grain diameter | Average grain diameter 25µm |
| Pressure | 0.2MPa |
| Number of shots | 14 |

### [Tenth example] Young's modulus = 200 GPa, dimensions of external shape = 32mm x 32mm, thickness of interposer = 400µm

For the interposer of the tenth example, the thickness of the substrate of a starting material in the seventh example was set to 400µm. Accompanied by that, sand blast condition for forming a through hole was changed to condition shown in the following table. Plating time for filling the through hole with conductive agent was changed corresponding to the thickness of the substrate. The other conditions were the same as the seventh example.

**[Table 10] Sand blast condition**

| | |
|---|---|
| Grain | Synthetic diamond |
| Grain diameter | Average grain diameter 25µm |
| Pressure | 0.2MPa |
| Number of shots | 60 |

### [Eleventh example] Young's modulus = 200 GPa, dimensions of external shape = 32mm x 32mm, thickness of interposer = 1000µm

For the interposer of the eleventh example, the thickness of the substrate of a starting material in the seventh example was set to 1000µm. Accompanied by that, sand blast condition for forming a through hole was changed to condition shown in the following table. Plating time for filling the through hole with conductive agent was changed corresponding to the thickness of the substrate. The other conditions were the same as the seventh example.

**[Table 11] Sand blast condition**

| | |
|---|---|
| Grain | Synthetic diamond |
| Grain diameter | Average grain diameter 25µm |
| Pressure | 0.2MPa |
| Number of shots | 150 |

### [Twelfth example] Young's modulus = 200 GPa, dimensions of external shape = 32mm x 32mm, thickness of interposer = 1500µm

For the interposer of the twelfth example, the thickness of the substrate of a starting material in the seventh example was set to 1500µm. Accompanied by that, sand blast condition for forming a through hole was changed to condition shown in the following table. Plating time for filling the through hole with conductive agent was changed corresponding to the thickness of the substrate. The other conditions were the same as the seventh example.

**[Table 12] Sand blast condition**

| | |
|---|---|
| Grain | Synthetic diamond |
| Grain diameter | Average grain diameter 25µm |
| Pressure | 0.2MPa |
| Number of shots | 230 |

### [13^{th} example] Young's modulus = 440 GPa, dimensions of external size = 32mm x 32mm, thickness of interposer = 50µm

The manufacturing method of a starting material of the 13^{th} example will be described.
(a) Acrylic base binder of 220g, B₄C as sintering assistant of 40g and alcoholic base solvent of 400 ml were mixed with SiC powder of 1 Kg having an average grain diameter of 0. 3µm. By mixing this mixture equally with a ball mill, high viscosity raw material slurry was prepared.
(b) Next, green sheet (52 to 57µm) was molded from raw material slurry according to doctor blade method.
(c) After the green sheet was degreased, it was hot-pressed at 2100°C under 18MPa and baked finally. As a consequence, the starting material of the interposer was obtained. This insulation base material was 50µm thick and 32 x 32mm. The thickness of the insulation base material may be adjusted by polishing after baking. By creating a green sheet 1.05 to 1.15mm thick in (b) and executing the treatment (c), a sample for measurement of Young's modulus was prepared. As a result of measuring this sample according to three-point-bending method based on JIS, the measured Young's modulus was 440GPa. (1) For the interposer of the 13^{th} example, the starting material of the seventh example was changed to a baked SIC substrate obtained in (c), whose dimensions in external shape were 32mm x 32mm and thickness was 50µm. The other things are the same as the seventh embodiment.

### [14^{th} example] Young's modulus = 440 GPa, dimensions of external size = 32mm x 32mm, thickness of interposer = 64µm

(1) Creation of starting material
   The thickness of the green sheet of the 13^{rd} example (b) was changed to 67 to 72µm and after that, by executing the process (c), a SiC substrate 64µm was obtained.
(2) Creation of interposer
   The starting material in the eighth example was changed to the one manufactured in (1). The other things are the same as the eighth example.

### [15^{th} example] Young's modulus = 440 GPa, dimensions of external size = 32mm x 32mm, thickness of interposer = 100µm

(1) Creation of starting material
   The thickness of the green sheet of the 13^{rd} example (b) was changed to 103 to 113µm and after that, by executing the process (c), a SiC substrate 100µm thick was obtained.
(2) Creation of interposer.
   The starting material in the ninth example was changed to the one manufactured in (1) . The other things are the same as the ninth example.

### [16^{th} example] Young's modulus = 440 GPa, dimensions of external size = 32mm x 32mm, thickness of interposer = 400µm

(1) Creation of starting material
   The thickness of the green sheet of the 13^{rd} example (b) was changed to 415 to 450µm and after that, by executing the process (c), a SiC substrate 400µm thick was obtained.
(2) Creation of interposer
   The starting material in the tenth example was changed to the one manufactured in (1). The other things are the same as the tenth example.

### [17^{th} example] Young's modulus = 440 GPa, dimensions of external size = 32mm x 32mm, thickness of interposer = 1000µm

(1) Creation of starting material
   The thickness of the green sheet of the 13^{rd} example (b) was changed to 1030 to 1150µm and after that, by executing the process (c), a SiC substrate 1000µm thick was obtained.
(2) Creation of interposer
   The starting material in the eleventh example was changed to the one manufactured in (1) . The other things are the same as the eleventh example.

### [18^{th} example] Young's modulus = 440 GPa, dimensions of external size = 32mm x 32mm, thickness of interposer = 1500µm

(1) Creation of starting material
   The thickness of the green sheet of the 13^{rd} example (b) was changed to 1550 to 1700µm and after that, by executing the process (c), a SiC substrate 1500µm thick was obtained.
(2) Creation of interposer
   The starting material in the twelfth example was changed to the one manufactured in (1) . The other things are the same as the twelfth example.

### [19^{th} example] Young's modulus = 200 GPa, dimensions of external shape = 24mm x 24mm, thickness of interposer = 100µm

The interposer of the 19^{th} example is the same as the ninth example except that the size of the external shape of the ninth example was changed to 24mm x 24mm.

### [20^{th} example] Young's modulus = 200 GPa, dimensions of external shape = 20mm x 20mm, thickness of interposer = 100µm

The interposer of the 20^{th} example is the same as the ninth example except that the size of the external shape of the ninth example was changed to 20mm x 20mm.

### [21^{st} example] Young's modulus = 200 GPa, dimensions of external shape = 40mm x 40mm, thickness of interposer = 100µm

The interposer of the 21st example is the same as the ninth example except that the size of the external shape of the ninth example was changed to 40mm x 40mm.

### [22^{nd} example] Young's modulus = 310 GPa, dimensions of external shape = 32 x 32mm, thickness of interposer = 400µm

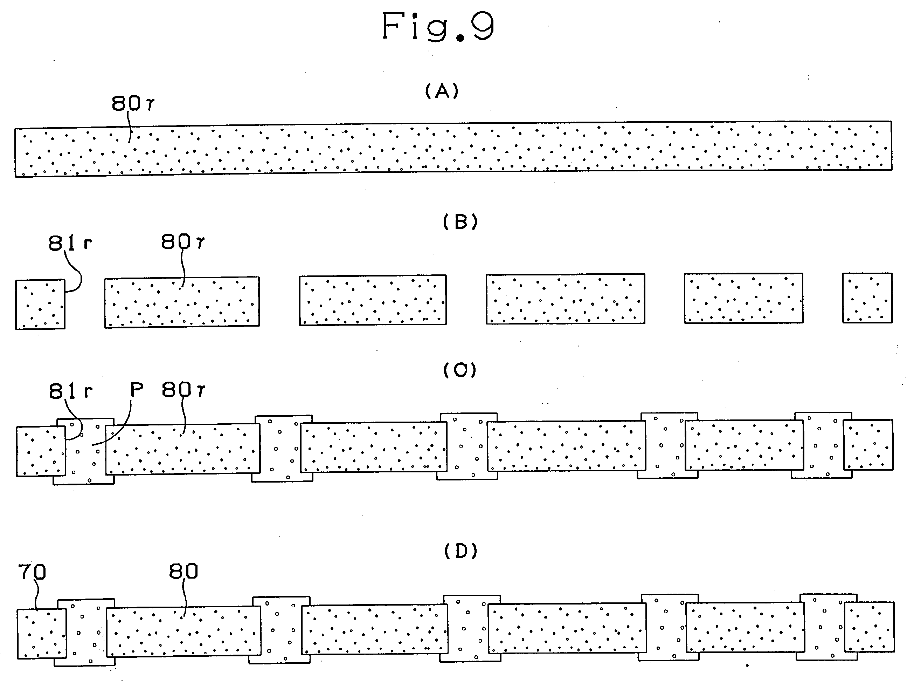

(1) Acrylic base binder of 220g, Y203 as sintering assistant of 50g and alcoholic base solvent of 400 ml were mixed with ALN powder (manufactured by TOKUYAMA)of 1 Kg having an average grain diameter of 1.4µm. By agitating this mixture equally with a ball mill, high viscosity raw material slurry was prepared.
(2) Next, green sheet 80γ(410 to 460µm) was molded from raw material slurry according to doctor blade method (see FIG. 9(A)).
(3) The through holes 81 (125µm in diameter) were formed at positions corresponding to the external electrodes of the IC in the green sheet 80γ one to one by punching, laser processing or drilling (see FIG. 9(B)). In the meantime, the power source and ground terminals of the IC are disposed in the form of a grid.
(4) Next, acrylic base binder of 2g, ether base solvent of 3ml and ether base dispersant of 3ml were mixed with tungsten power of 100g having an average grain diameter of 3µm. This mixture was agitated equally with a three-roll mill so as to obtain tungsten paste P for formation of conductor circuit.
(5) Then, paste P was printed in the through hole 81γ of the green sheet 80γ by means of a screen printing machine. As a result as shown in FIG. 9(C), the through hole 81γ was filled with paste P and a circular portion was formed with paste P on the upper and lower faces of the through hole 81γ.
(6) Next, the green sheet 80γ was inserted into a drier and the green sheet 80γ was heated at a temperature rising speed of 50°C/minute. Then, after the temperature inside the drier reached 150°C, that temperature was maintained for about 24 hours so as to dry the green sheet 80γ sufficiently and after that, it was left so that it cooled to a room temperature.
(7) Subsequently, the green sheet 80γ was degreased and baked temporarily at 1, 600°C for five hours under inert environment. Further, it was baked finally at 1,850°C for three hours under the same atmosphere. As a consequence, the interposer 70 manufactured by ALN was obtained (see FIG. 9(D)). This interposer 70 was 400µm thick and 32 x 32mm in dimension.

### (Measurement of Young's modulus)

### An ALN substrate 1mm thick was produced in the aforementioned processes (1), (2), (6), (7) and the measurement was made according to three-point-bending method based on JIS. Its result was 310Gpa. In the meantime, the green sheet was produced in the thickness of 1.02 to 1.15 mm.

[23^{rd} example] Young's modulus = 310 GPa, dimensions of external shape 32 x 32mm, thickness of interposer = 50µm
(1) For the interposer of the 23^{rd} example, the starting material was changed to baked ALN substrate having an external shape size of 32 x 32mm and a thickness of 50µm. This ALN substrate was produced in the processes (1), (2), (6), (7) of the 22^{nd} example. In the meantime, the thickness of the green sheet was set to 52 to 57µm. The thickness of the insulation base material may be adjusted by polishing after sintering. The other things are the same as the seventh example.

### [24^{th} example] Young's modulus = 310GPa, dimensions of external shape 32 x 32 mm, thickness of interposer = 64µm

(1) For the interposer of the 24^{th} example, the starting material of the eighth example was changed to a baked ALN substrate having an external shape size of 32 x 32mm and a thickness of 64µm. This ALN substrate was produced in the processes (1), (2), (6), (7) of the 22^{nd} example. In the meantime, the thickness of the green sheet in (2) was set to 67 to 72µm. The thickness of the insulation base material may be adjusted by polishing after sintering. The other things are the same as the eighth example.

### [25^{th} example] Young's modulus = 310GPa, dimensions of external shape 32 x 32 mm, thickness of interposer = 100µm

(1) For the interposer of the 25^{th} example, the starting material of the ninth example was changed to a baked ALN substrate having an external shape size of 32 x 32mm and a thickness of 100µm. This ALN substrate was produced in the processes (1), (2), (6), (7) of the 22^{nd} example. In the meantime, the thickness of the green sheet in (2) was set to 103 to 113µm. The thickness of the insulation base material may be adjusted by polishing after sintering. The other things are the same as the ninth example.

### [26^{th} example] Young's modulus = 310GPa, dimensions of external shape 32 x 32 mm, thickness of interposer = 400µm

(1) For the interposer of the 26^{th} example, the starting material of the tenth example was changed to a baked ALN substrate having an external shape size of 32 x 32mm and a thickness of 400µm. This ALN substrate was produced in the processes (1), (2), (6), (7) of the 22^{nd} example. In the meantime, the thickness of the green sheet in (2) was set to 415 to 450µm. The thickness of the insulation base material may be adjusted by polishing after sintering. The other things are the same as the tenth example.

### [27^{th} example] Young's modulus = 310GPa, dimensions of external shape 32 x 32 mm, thickness of interposer = 1000µm

(1) For the interposer of the 27^{th} example, the starting material of the eleventh example was changed to a baked ALN substrate having an external shape size of 32 x 32mm and a thickness of 1000µm. This ALN substrate was produced in the processes (1), (2), (6), (7) of the 22^{nd} example. In the meantime, the thickness of the green sheet in (2) was set to 1030 to 1150pm.. The thickness of the insulation base material may be adjusted by polishing after sintering. The other things are the same as the eleventh example.

### [28^{th} example] Young's modulus = 310GPa, dimensions of external shape 32 x 32 mm, thickness of interposer = 1500µm

(1) For the interposer of the 28^{th} example, the starting material of the twelfth example was changed to a baked ALN substrate having an external shape size of 32 x 32mm and a thickness of 1500µm. This ALN substrate was produced in the processes (1), (2), (6), (7) of the 22^{nd} example. In the meantime, the thickness of the green sheet in (2) was set to 1550 to 1700µm. The thickness of the insulation base material may be adjusted by polishing after sintering. The other things are the same as the twelfth example.

### [29^{th} example] Young' s modulus = 55 GPa, dimensions of external shape 32 x 32mm, thickness of interposer = 50µm

(1) For the interposer of the 29^{th} example, the starting material of the seventh example was changed to a SF2 glass substrate (manufactured by Schott, glass coat; 648339) having an external shape size of 32 x 32mm and a thickness of 50µm. The thickness was adjusted by polishing. The Young's modulus of this insulation substrate was 55 GPa as a result of measurement according to three-point-bending method. In the meantime, an insulation base material 1mm thick was used for measurement of the Young's modulus. The other things are the same as the seventh example.

### [30^{th} example] Young's modulus = 55 GPa, dimensions of external shape 32 x 32mm, thickness of interposer = 64µm

(1) For the interposer of the 30^{th} example, the starting material of the eighth example was changed to a SF2 glass substrate (manufactured by Schott, glass coat; 648339) having an external shape size of 32 x 32mm and a thickness of 64µm. The thickness was adjusted by polishing. The other things are the same as the eighth example.

### [31^{st} example] Young's modulus = 55 GPa, dimensions of external shape 32 x 32mm, thickness of interposer = 100µm

(1) For the interposer of the 31^{st} example, the starting material of the ninth example was changed to a SF2 glass substrate (manufactured by Schott, glass coat; 648339) having an external shape size of 32 x 32mm and a thickness of 100µm. The thickness was adjusted by polishing. The other things are the same as the ninth example.

### [32^{nd} example] Young's modulus = 55 GPa, dimensions of external shape 32 x 32mm, thickness of interposer = 400µm

(1) For the interposer of the 32^{nd} example, the starting material of the tenth example was changed to a SF2 glass substrate (manufactured by Schott, glass coat; 648339) having an external shape size of 32 x 32mm and a thickness of 400µm. The thickness was adjusted by polishing. The other things are the same as the tenth example.

### [33^{rd} example] Young's modulus = 55 GPa, dimensions of external shape 32 x 32mm, thickness of interposer = 1000µm

(1) For the interposer of the 33^{rd} example, the starting material of the eleventh example was changed to a SF2 glass substrate (manufactured by Schott, glass coat; 648339) having an external shape size of 32 x 32mm and a thickness of 1000µm. The thickness was adjusted by polishing. The other things are the same as the eleventh example.

### [34^{th} example] Young's modulus = 55 GPa, dimensions of external shape 32 x 32mm, thickness of interposer = 1500µm

(1) For the interposer of the 34^{th} example, the starting material of the twelfth example was changed to a SF2 glass substrate (manufactured by Schott, glass coat; 648339) having an external shape size of 32 x 32mm and a thickness of 1500µm. The thickness was adjusted by polishing. The other things are the same as the twelfth example.
35^{th} to 40^{th} examples]

The starting material of the seventh to twelfth examples was changed to pyrex glass substrate (manufactured by CORNING INCORPORATED). The Young's modulus of this insulation base material was 65.5GPa as a result of measurement according to three-point-bending method based on JIS.

### [First experimental example]

The through hole formation area and the quantity of the through holes in the interposer were set equal to the ninth example and then, the through holes connected to the power source and ground terminal of the IC were disposed at random. As a result, there were produced an area in which the through holes existed densely and an area in which they existed non-densely. The other things than the disposition of the through holes are the same as the ninth example.

### [Second experimental example]

The through hole formation area and the quantity of the through holes in the interposer were set equal to the ninth example and then, the through holes connected to the power source and ground terminal of the IC were disposed in a staggered fashion. The other things than the disposition of the through holes are the same as the ninth example. When an IC was loaded on the interposer of the first and second experimental examples, an IC meeting the disposition of the through holes in the interposer was used.

### [41^{st} example] Young's modulus = 65.5GPa, dimensions of external shape = 32mm x 32mm, thickness of interposer = 50µm, diameter of opening in an end face of through hole/diameter of opening in the center = 1.02

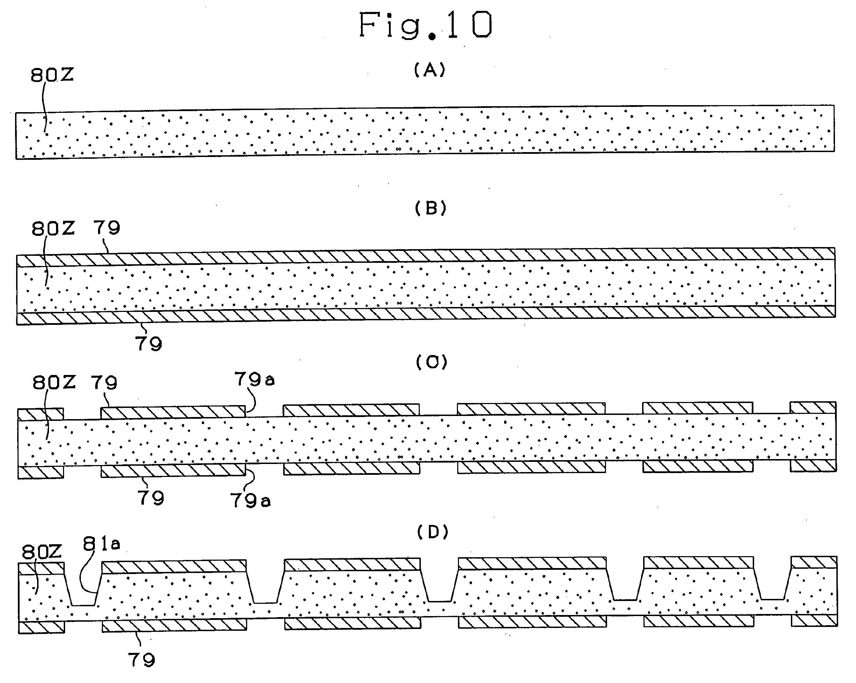

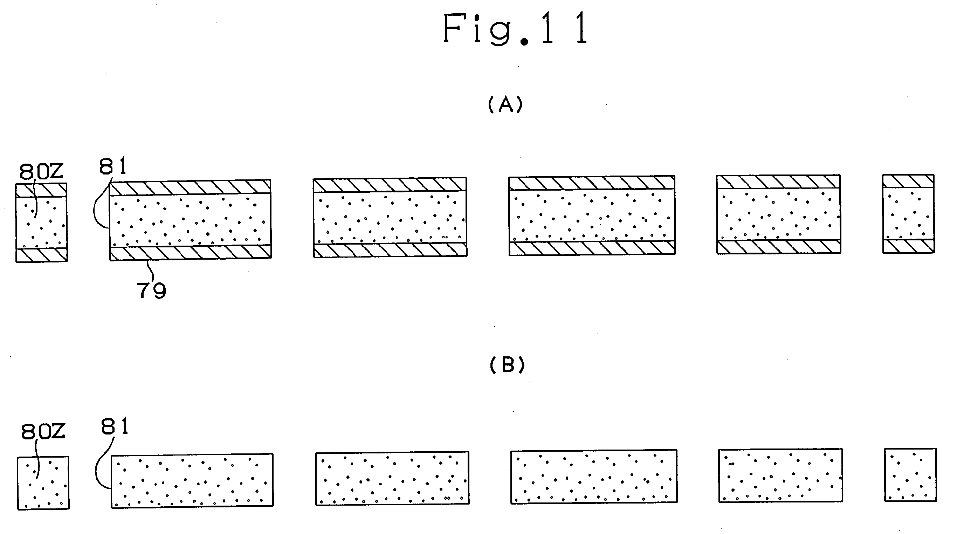

The manufacturing method of the interposer of the 22^{nd} example will be described with reference to FIGS. 10, 11.
(1) As a starting material, pyrex glass substrate (manufactured by CORNING INCORPORATED) 80Z was used (FIG. 10(A)). Urethane base resist 79 was pasted to both faces of this substrate 80 (FIG. 10(B)) and an opening 79a 125µm was formed at a position corresponding to the external electrode of the IC according to the ordinary photography method (FIG. 10(C)).
(2) The openings 81a were formed substantially up to the center of the insulation base material 80 by executing sand blast treatment from a face according to the condition of Table 13 (FIG. 10 (D)) and after that, by executing sand blast treatment from the other face according to the condition of Table 14 , the through holes 81 were completed (FIG. 11A) . Then, the resist 79 was peeled off (FIG. 11 (B)) . The diameters of the through hole at both end faces of the substrate and its minimum portion were measured with a digital microscope (manufactured by KEYENCE CORPORATION (VH-Z250)). The diameter of the opening at both end portions was 125.0µm and the diameter of the opening at the minimum portion was 122.5µm. Because following process is the same as the seventh example described with reference to FIGS. 7(D) to 8, description thereof is omitted.

**[Table 13] Sand blast condition from a face**

| | |
|---|---|
| Grain | Synthetic diamond |
| Grain diameter | 25µm |
| Pressure | 0.2MPa |
| Number of shots | 4 |

**[Table 14] Sand blast condition from the other face**

| | |
|---|---|
| Grain | Synthetic diamond |
| Grain diameter | 25µm |
| Pressure | 0.19MPa |
| Number of shots | 3 |

### [42^{nd} example] Young's modulus = 65.5GPa, dimensions of external shape = 32mm x 32mm, thickness of interposer = 50µm, diameter of opening in end face of through hole/diameter of opening in the center = 5

(1) The interposer of the 42^{nd} example is the same as the 41^{st} example except that the sand blast condition for forming the through hole in the interposer was changed as shown in Table 15, Table 16 described below.

**[Table 15] Sand blast condition from a face**

| | |
|---|---|
| Grain | Synthetic diamond |
| Grain diameter | Average diameter 25µm |
| Pressure | 0.2MPa |
| Number of shots | 2 |

**[Table 16] Sand blast condition from the other face**

| | |
|---|---|
| Grain | Synthetic diamond |
| Grain diameter | Average diameter 25µm |
| Pressure | 0.2MPa |
| Number of shots | 2 |

### [43^{rd} example]

The interposer of the 43^{rd} example is the same as the 42^{nd} example. In the 42^{nd} example, the via holes were produced by filling with plating. Contrary to this, in the 43^{rd} example, the via holes were produced by filling the through holes 81 in the substrate 80 with low melting point metal paste such as solder. According to the 42^{nd} example, the via holes are softer than the first to 43^{rd} examples and its stress absorption capacity is high.

### [First comparative example] Young's modulus = 50GPa, dimensions of external shape = 32mm x 32mm, thickness of interposer = 100µm

Because the manufacturing method of the first comparative example is the same as the first example, description thereof is omitted.
(1) 100 weight part of bisphenol A type epoxy resin, 5 weight part of imidazole type hardening agent and 50 weight part of alumina filler were mixed and that resin was impregnated into glass cloth and dried to obtain prepreg 80 as B stage. Single face copper clad laminate 80A obtained by laminating the prepreg 80 and copper foil 78 and then pressing with heat under pressure was used as a starting material. The thickness of this insulating base material 80 is 100µm and the thickness of the copper foil 78 is 12µm. The Young's modulus of the insulating substrate was 50GPa as a result of measurement according to three-point-bending method based on JIS. In the meantime, an insulating base material 1mm thick was used for this measurement of Young's modulus. Following process is the same as the first example.

### [Second comparative example] Young's modulus = 470 GPa, dimensions of external shape = 32mm x 32mm, thickness of interposer = 100µm

(1) A sapphire substrate (manufactured by KYOCERA CORPORATION) 32mm x 32mm and 100µm thick was used as a starting material. The Young's modulus of this insulating substrate was 470GPa as a result of measurement according to three-point-bending method. In the meantime, an insulating base material 1mm thick was used for the measurement of Young's modulus. The other things were the same as the ninth example.

### [Third comparative example] Young's modulus = 200GPa, dimensions of external shape = 32mm x 32mm, thickness of interposer = 45µm

For the interposer of the third comparative example, the thickness of the substrate of a starting material of the seventh example was set to 45µm. Accompanied by this, the sand blast condition for forming the through holes was changed to the condition indicated in Table 17 shown below. Plating time for filling the through holes with conductive agent was changed corresponding to the thickness of the substrate. The other things are the same as the seventh example.

**[Table 17] Sand blast condition**

| | |
|---|---|
| Grain | Synthetic diamond |
| Grain diameter | Average diameter 25µm |
| Pressure | 0.2MPa |
| Number of shots | 6 |

### [Fourth comparative example] Young's modulus = 200GPa, dimensions of external shape = 32mm x 32mm, thickness of interposer = 1600µm

For the interposer of the fourth comparative example, the thickness of the substrate of a starting material of the seventh example was set to 1600µm. Accompanied by this, the sand blast condition for forming the through holes was changed to the condition indicated in Table 18 shown below. Plating time for filling the through holes with conductive agent was changed corresponding to the thickness of the substrate. The other things are the same as the seventh embodiment.

**[Table 18] Sand blast condition**

| | |
|---|---|
| Grain | Synthetic diamond |
| Grain diameter | Average diameter 25µm |
| Pressure | 0.2MPa |
| Number of shots | 250 |

### [Fifth comparative example] Young's modulus = 55GPa, dimensions of external shape = 15mm x 15mm, thickness of interposer = 50µm

For the interposer of the fifth comparative example, its manufacturing condition is the same as the first example except that the dimensions of the external shape was set to 15mm x 15mm.

### [Sixth comparative example] Young's modulus = 55GPa, dimensions of external shape = 45mm x 45mm, thickness of interposer = 50µm

For the interposer of the sixth comparative example, its manufacturing condition is the same as the first example except that the dimensions of the external shape was set to 45mm x 45mm.

### [Seventh comparative example] Young's modulus = 65.5GPa, dimensions of external shape = 32mm x 32mm, thickness of interposer = 50µm, diameter of opening in an end face of through hole/diameter of opening in the center = 5.5

(1) For the interposer of the seventh comparative example, its manufacturing condition is the same as the 41^{st} example except that the sand blast condition for forming the through holes in the interposer was changed to Table 19, Table 20 shown below.

**[Table 19] Sand blast condition from a face**

| | |
|---|---|
| Grain | Synthetic diamond |
| Grain diameter | Average.diameter 25µm |
| Pressure | 0.19MPa |
| Number of shots | 2 |

**[Table 20] Sand blast condition from the other face**

| | |
|---|---|
| Grain | Synthetic diamond |
| Grain diameter | Average diameter 25µm |
| Pressure | 0.19MPa |
| Number of shots | 2 |

### [Third experimental example]

The quantity of terminals was set equal to the ninth example and the pitch of through holes for connecting the power source and ground terminals of the IC was changed to 120µm (diameter of the through hole was set to 60µm in diameter). Accompanied by this, the electrode pitch of the IC chip to be connected in a subsequent process was set to 120µm.

### [Fourth experimental example]

According to the fourth experimental example, the through holes of the third experimental example was disposed in the staggered fashion.

### 3. Manufacturing of semiconductor

Mounting of the interposer and IC chip onto the package substrate 10 shown in FIG. 1 will be described with reference to FIGS. 2, 3.
(1) After the interposer 70 (first to 43^{rd} example, first and second experimental examples, first to seventh comparative examples) shown in FIG. 8 (D) was positioned and mounted on the package board 10 shown in FIG. 1, it was connected by reflowing.
(2) After marketed sealing agent (under-fill) 68 was charged between the interposer 70 and the resin made package substrate 10, it was hardened for 15 minutes under 80°C and for two hours under 150°C (FIG. 2).
(3) Next, after an IC chip 110 20mm x 20mm was positioned and mounted on the interposer 70, it was installed by reflowing.

Finally, after sealing agent (under-fill) 69 was charged between the interposer 70 and the IC chip 110, it was hardened for 15 minutes under 80°C and subsequently for two hours under 150°C (FIG. 3)

### 4. Heat cycle test

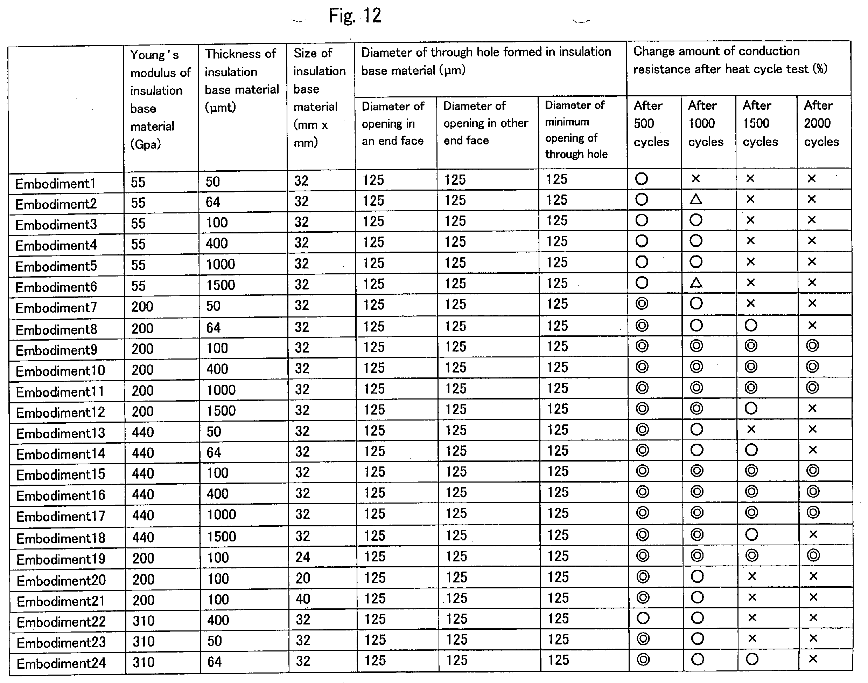

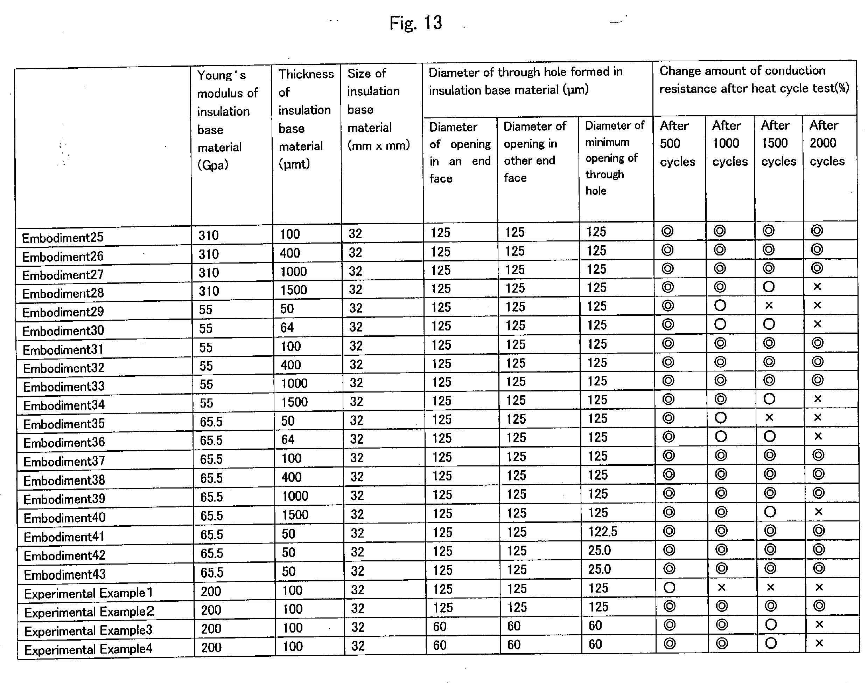

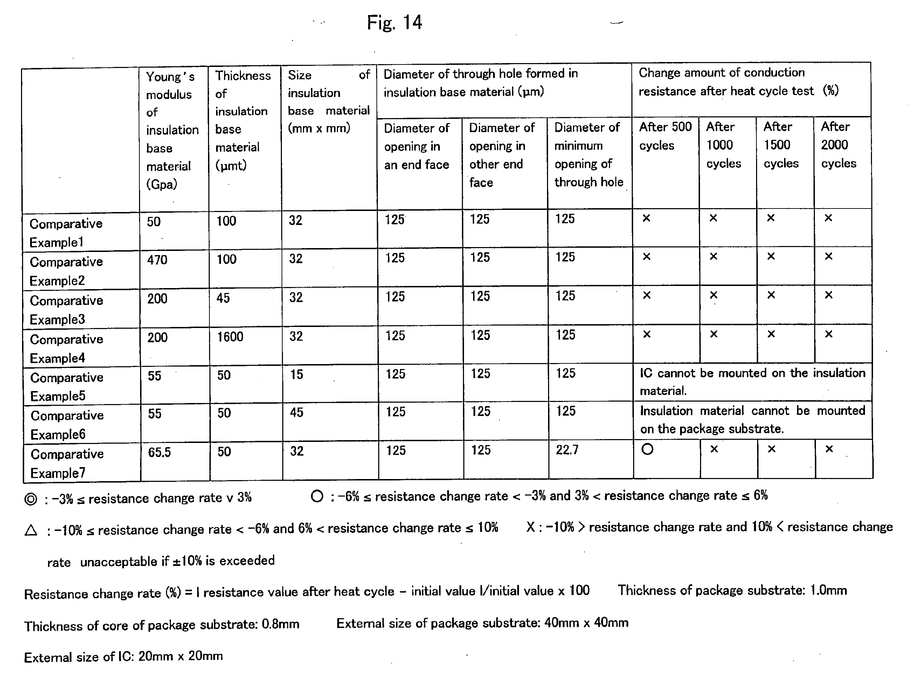

Various semiconductor devices manufactured in 3 were applied to heat cycle test (-55°C* 30 minutes ↔ 120°C* 30 minutes) so as to measure resistance values of wiring from a measuring terminal on the rear surface of the package to wiring including via hole and through hole in the package substrate to through hole conductor in the interposer to wiring of the IC chip to through hole conductor in the interposer to wiring including via hole and through hole in the package substrate to measuring terminal on the rear surface of package before heat cycle test (initial value), 50 cycles after, 1000 cycles after, 1500 cycles after, 2000 cycles after. This result is shown in FIGS. 12, 13, 14. If the shift amount of resistance is within ±10%, it is acceptable. The Young's modulus of the insulation base material constituting the interposer is preferred to be 55 to 440GPa. According to thermal stress analysis on the semiconductor device at the time of mounting the substrate conducted by the inventor, if the Young's modulus of the interposer is within the above-mentioned range, the amount of deformation by thermal stress or the like of the IC chip, interposer and resin made package gets into the relation of IC ≒(almost equal to) interposer<package substrate. Under such a relation, stress due to difference in thermal expansion between the ceramic made IC and resin made package substrate is received by the interposer so that the stress is not transmitted to resin in the wiring layer of the IC . As a result, it was evident that no crevice or breaking occurred in resin of the wiring layer of the IC. If the Young's modulus of the interposer decreases, the amount of deformation of the interposer due to the stress increases. If the Young's modulus of the interposer becomes less than 55GPa, the difference in the amount of deformation between the IC and interposer increases. Thus, it was made evident that the resin of the wiring layer of the IC could not bear stress generated due to that difference, so that crevice and breaking occurred in resin of the wiring layer of the IC . It was evident that if the Young's modulus exceeded 440GPa, crevice and breaking occurred in resin of the insulation layer of the IC because the stiffness of the interposer was too high.

If comparing the first to 43^{rd} examples with the first to fourth comparative examples after 500 cycles in heat cycle, the result is O or higher for any one of the first to 43^{rd} examples and it is X in any one of the first to fourth comparative examples. As a result, it is evident that if the Young's modulus of the insulation base material of the interposer is 55 to 440GPa and its thickness is 0. 05 to 1. 5 times the package substrate, the heat resistance cycle performance of the substrate loaded with the IC is improved.

Further, evidently, from comparison of the ninth, 19^{th}, 20^{th} and 21^{st} examples, the insulation base material is preferred to be large than the IC chip and smaller than the package substrate.

From comparison of the ninth example with the first experimental example, it is evident that the heat resistance cycle performance of a substrate loaded with the IC differs depending on the arrangement of the through holes. The arrangement in the form of a grid or in the staggered fashion is preferred.

### 5. Checking of void in sealing agent

After the heat cycle test, the semiconductor devices (100 pieces) of the ninth, 19^{th}, 20^{th}, and 21^{st} examples were flat polished up to about 1/2 the thickness of the sealing agent from the side of the IC and a percentage of generation of voids in the sealing agent was measured (quantity of semiconductor devices having voids/100 x 100)

**[Table 21] Percentage of generation of voids in sealing agent**

| Example | Percentage of generation of void (%) |
|---|---|
| Example 9 | 0 |
| Example 19 | 0 |
| Example 20 | 14 |
| Example 21 | 19 |

From this result, it is evident that the charging characteristic of the sealing agent changes depending on the size of the interposer, affecting the connection reliability. That is, it could be verified that projection area of electronic component loaded on the interposer≤area of insulation base material constituting the interposer≤projection area of package substrate x 1 and projection area of electronic component x 1.2≤area of insulation base material constituting the interposersprojection area of package substrate x 0.8 is preferable.

### 6. Checking of void in conductive substance

By polishing the sections of 100 through hole portions of insulation base materials of the 35^{th}, 41^{st}and 42^{nd} examples and the seventh comparative example, the percentage of generation of void was measured (quantity of through holes containing void/100 x 100)

**[Table 22] Voids in conductive substance**

| Example, comparative example | Percentage of generation of void (%) |
|---|---|
| Example 35 | 7 |
| Example 41 | 0 |
| Example 42 | 0 |
| Comparative example 7 | 32 |

From this result, it is evident that the sectional shape of a through hole affects the charging characteristic of conductive substance. As for the sectional shape of the through hole in the interposer, preferably, the diameter of an opening in at least an end face is larger than the diameter of a hole in the center of the through hole. More preferably, the relation of the diameter of an opening in an end face/a minimum diameter of the through hole is 1.02 to 5.0. If it is less than 1, it is difficult to charge the inside of the through hole with conductive substance without any non-charging. If it is 1.02 or more, the diameter of an opening in the end face of the through hole becomes larger than the other through hole portions and thus, conductive substance is charged easily. As a result, voids vanish.

### 7. Confirmation of advancement direction of crack

The section of a semiconductor package was polished after 2000 cycles in heat cycle of the 35^{th} example and seventh comparative example so as to confirm the direction of crack in a joint portion.

**[Table 23] Advancement direction of crack**

| Comparative example | Advancement direction of crack |
|---|---|
| Example 35 | Perpendicular to interposer |
| Comparative example 7 | Generated along taper of through hole |

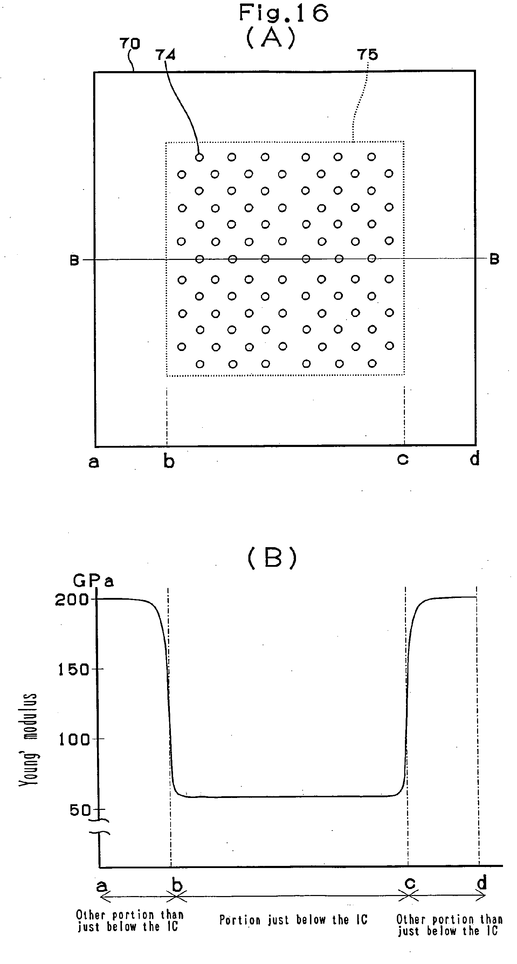

As a result of observation of the section, it is evident that crack occurred from a portion of the minimum via diameter as a starting point in the seventh comparative example and reached a joint portion along the inner wall of the through hole. Consequently, it has been verified that stress propagates to the joint portion along the inner wall of the through hole. That is, the taper of the sectional shape of the through hole is effective for relaxing stress because stress is not transmitted straight to the joint portion.
Evaluation test 1 : FIG. 16 (B) shows Young's modulus on line B-B (FIG.16-1) calculated by simulation (3D strip simulation) with an insulation base material (interposer) 70 shown in FIG. 16(A) taken as an objective. In FIG. 16(A), through holes 74 in a just-below-the IC chip portion 75 are disposed by 77 x 77.

From FIG. 16(B), it is evident that as for the physical property of the insulation base material (interposer), Young's modulus has changed across the just-below-the IC chip portion.

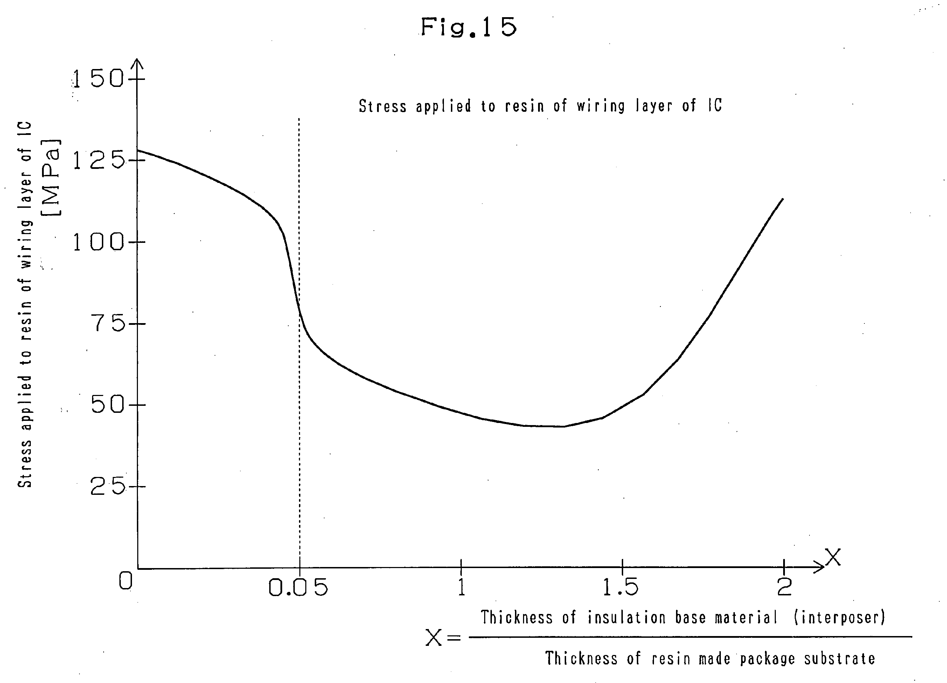

The thermal expansion coefficient of the insulation base material (interposer) has the same tendency although not shown.
Evaluation test 2: FIG. 15 shows a relation between the thickness of the insulation base material (interposer) and stress applied to resin of the wiring layer of the IC calculated by 3D strip simulation with Young's modulus, Poission ratio and thermal expansion coefficient inputted assuming that materials of the interposer, conductor, IC chip, package substrate and the like are the same. The Young's modulus of the insulation base material was assumed to be 200GPa.

As evident from this diagram, if the thickness of the insulation base material (interposer) is 0.05 to 1.5 times the thickness of the package substrate, stress applied to resin of the wiring layer of the IC decreases. Therefore, if the thickness of the insulation base material (interposer) is 0.05 to 1.5 times the thickness of the package substrate, resin of the wiring layer of the IC is difficult to destroy.

From the result of the heat cycle test, it is evident that even if the Young's modulus of the insulation substrate is 55 to 440GPa and the thickness thereof is 0.05 to 1.5 times that of the package substrate, the service life of the heat cycle test differs depending on the kind of the insulation substrate.

If comparing test results of the 22^{nd} example and 26^{th} example after 1500 cycles, although the 26^{th} example using a baked substrate as its starting material indicates double circles ⊚, the 22^{nd} example indicates a cross X. Because in the 26^{th} example, the through holes are formed in the baked substrate, it is estimated that the accuracy of matching between the through hole conductor and IC chip terminal/package substrate terminal is favorable.

Contrary to this, as regards the 22^{nd} example, it is estimated that the through hole conductor deflects with respect to the IC chip terminal position or package board terminal position due to contraction or warpage because baking process under high temperatures is executed after the through hole conductor is formed so that contact area between the IC chip terminal and package substrate terminal decreases. It can be considered that a difference exists between the both due to this difference.

## Claims

1. An interposer to be located between a package substrate made of resin and an IC chip, having a plurality of through holes and in which a through hole conductor for connecting said package substrate with the IC chip electrically is formed, wherein Young's modulus of insulation base material constituting said interposer is 55 to 440GPa and the thickness of said insulation base material is the thickness of the package substrate x 0.05 or more to the thickness of the package substrate x 1.5 or less.

2. The interposer according to claim 1 wherein the thickness of said insulation base material is the thickness of core of the package substrate x 0.08 or more.

3. The interposer according to claim 1 or 2 wherein the size of said insulation base material is equal to or larger than the projection area of an electronic component loaded on the interposer and equal to or less than the projection area of the package substrate.

4. The interposer according to claim 1, 2, 3 wherein of external electrode terminals formed in the IC chip, arrangement of the through holes in said insulation base material connected to a power source terminal and a ground terminal is in the form of a grid or in a staggered fashion.

5. The interposer according to claim 1-4 wherein said package substrate is a multilayer printed wiring board.

6. The interposer according to claim 1-5 wherein said through hole conductor is made of metal plating.

7. The interposer according to claim 1-5 wherein said through hole conductor is made of metallic paste.

8. The interposer according to claim 1-7 wherein as regards the sectional shape of a through hole in the insulation base material, the diameter of an opening in at least an end face is equal to or larger than the diameter of a hole in the center of the through hole.

9. A multilayer printed wiring board having any one of the interposers according to claim 1-8.
